# EUROPEAN PATENT SPECIFICATION

(11) **EP 0 275 209 B1**
(45) Date of publication and mention of the grant of the patent: **27.10.1993**
(21) Application number: 88300330.3
(22) Date of filing: 15.01.1988
(51) Int. Cl.: H01S 3/19

(54) **A semi conductor laser device**
Halbleiterlaser-Vorrichtung
Dispositif laser à semi-conducteur

(30) Priority: 16.01.1987 JP 8833/87
(43) Date of publication of application: 20.07.1988
(73) Proprietor: SHARP KABUSHIKI KAISHA, Osaka 545 (JP)
(72) Inventor: Takiguchi, Haruhisa, Nara-shi Nara-ken (JP); Kaneiwa, Shinji, Nara-shi Nara-ken (JP); Kudo, Hiroaki, Tenri-shi Nara-ken (JP); Sakane, Chitose, Tenri-shi Nara-ken (JP); Yoshida, Toshihiko, Tenri-shi Nara-ken (JP)
(74) Representative: Huntingford, David Ian

(56) References cited:
- US-A- 4 480 331
- US-A- 4 573 161
- US-A- 4 631 802
- US-A- 4 635 268
- PATENT ABSTRACTS OF JAPAN, unexamined applications, E section, vol. 11, no. 41, February 6, 1987 THE PATENT OFFICE JAPANESE GOVERNMENT, page 83 E 478

## Description

The present invention relates to a semiconductor laser device.

In recent years, molecular beam epitaxy (MBE) and metal organic-chemical vapour deposition (MO-CVD) had been used as crystal layer growth methods for the production of semiconductor laser devices, especially GsAlAs semiconductor laser devices. Reference is directed in this connection to Japanese Journal of Applied Physics, Vol.24, No.2, 1985 pp L89-L90 (Single-Longitudinal-Mode Self Aligned (AlGa)As Double-Beam Heterostructure Lasers fabricated by Molecular Beam Epitaxy).

According to these growth methods, a striped channel provided for the confinement of current therein, which channel is formed on the substrate, cannot be buried by a semiconductor material during a crystal growth process and a growth layer, having a uniform thickness, is formed within the striped channel in accordance with the shape of the striped channel. Accordingly, a built-in structure for confining current and carrier therein cannot be formed until a double- heterostructure in which an active layer is sandwiched between a pair of cladding layers has been disposed on the substrate.

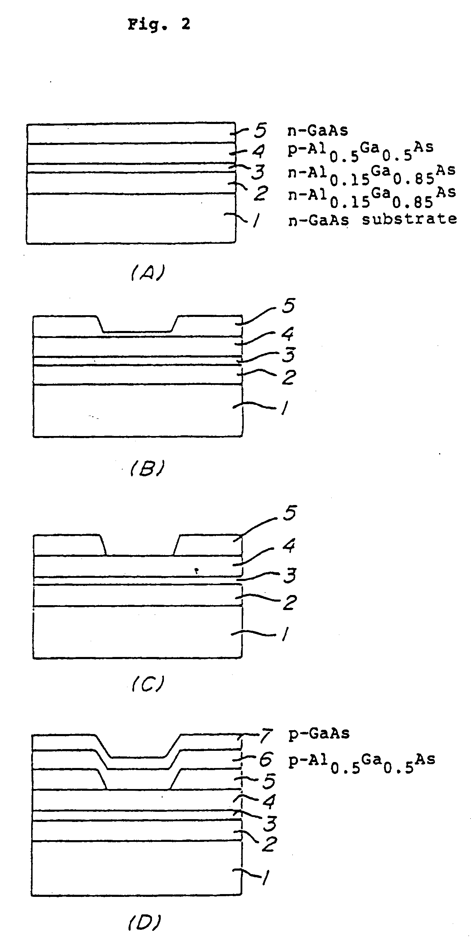

Figs. 2(A) to 2(D) illustrate the above-mentioned method in which, as shown in Fig. 2(A), a double- heterostructure for sandwiching an n-active layer 3 between the n-cladding layer 2 and the p-cladding layer 4 is formed on an n-GaAs substrate 1, and then an n-GaAs current blocking layer 5 having a conductive type different to that of the p-cladding layer 4 is formed on the p-cladding layer 4. Next, a striped channel is formed in the current blocking layer 5 by an etching technique, as in Fig. 2(B), in such a manner that the striped channel does not reach the p-Al_{0.5}Ga_{0.5}As cladding layer 4. If the groove reaches the p-cladding layer 4, so as to expose the p-cladding layer 4, the exposed surface of the p-cladding layer 4 is oxidized, which makes any succeeding epitaxial crystal growth impossible.

Then, the wafer with the above-mentioned striped channel is fed to the growth chamber of a MBE or MO-CVD apparatus. When the wafer is subjected to a molecular beam epitaxial treatment in the growth chamber, it is heated to a temperature of 800°C while being irradiated with As molecular beams. When the wafer undergoes a metal organic-chemical vapour deposition treatment, it is heated up to a temperature of 800°C while being irradiated with AsH₃ gas. By such a heating treatment, as shown in Fig. 2(C), the bottom portion of the striped channel of the current blocking layer 5 is etched so that the portion of the p-cladding layer 4, corresponding to the striped channel in the current blocking layer 5, is exposed. Then, as shown in Fig. 2(D), a p-Al_{0.5}Ga_{0.5}As layer 6 and a p-GaAs cap layer 7 are successively grown on the wafer, resulting in a semiconductor laser device in which the n-GaAs current blocking layer 5 functions to confine current and light therein.

However, use of the above-mentioned production process creates at least two difficult problems. Firstly, in the step shown in Fig. 2(B), it is very difficult to accurately time the cut off of the etching treatment and so thereby leave the wafer with a thin portion of the n-GaAs current blocking layer corresponding to the bottom portion of the striped channel. Secondly, in the step shown in Fig. 2(C), when the portion of the n-GaAs current blocking layer 5, corresponding to the bottom portion of the striped channel, is subjected to a heat-etching treatment, it is very difficult to remove said portion of the current blocking layer 5 without thermally damaging the p-AlGaAs cladding layer 4.

It is an object of the present invention to provide a semiconductor laser device, which overcomes the above-discussed and other disadvantages and deficiencies of the known devices.

In accordance with the present invention there is provided a semiconductor laser device comprising a double-heterostructure that is composed of an active layer and a pair of cladding layers sandwiching said active layer therebetween, and a stripe structure that is disposed on said double-heterostructure, said stripe structure being composed of a current blocking layer with a conductivity type different from that of the adjacent cladding layer, and said current blocking layer having a striped channel constituting a current path characterised in that said cladding layer that contacts the current blocking layer is composed of an In₁₋ₛGaₛP₁₋ₜAsₜ crystal material, wherein 0.51 ≦ s ≦ 1, 0 ≦ t ≦ 1 and t=2.04s - 1.04, and wherein said current blocking layer (5) is composed of a GaAs crystal material.

Preferably, the active layer is composed of a GaAlAs crystal material or advantageously it is composed of an In_{1-y}Ga_{y}P_{1-z}As_{z} crystal material, wherein 0.51 ≦ y ≦ 1, 0 ≦ z ≦ 1 and z=2.04y - 1.04.

Thus the present invention makes possible the provision of a semiconductor laser device in which a striped structure for confining current therein is disposed on a crystal material which does not contain any components which are readily oxidized, and accordingly, complicated processes which are necessary to prevent the oxidation of the components are not required. This allows the said laser device to attain stabilized laser oscillation.

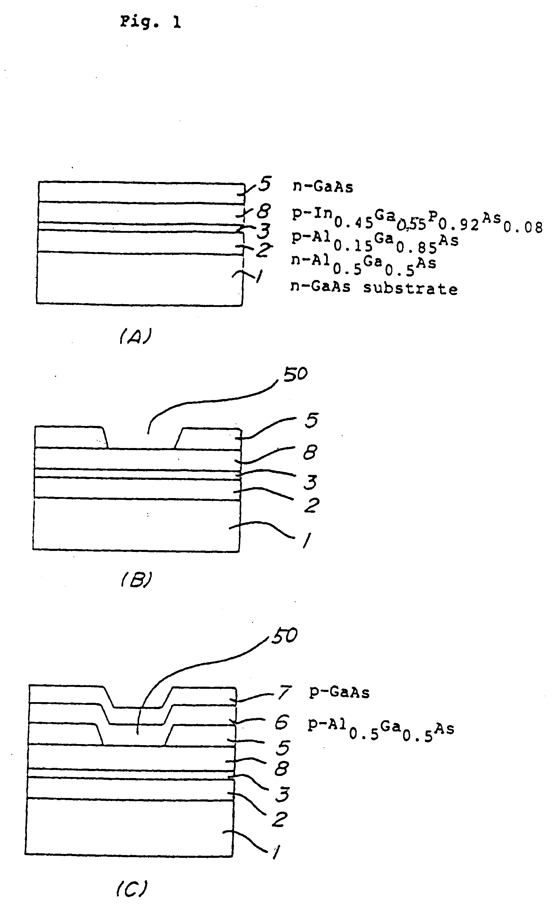

The invention is described further hereinafter by way of example only, with reference to Figs. 1a to 1c of the accompanying drawings which show four stages in the fabrication of a semiconductor laser device in acordance with the present invention.

As shown in Fig. 1(A), on an n-GaAs substrate 1, an n-Al_{0.5}Ga_{0.5}As light and carrier confining cladding layer 2 and a p-Al_{0.15}Ga_{0.85}As active layer 3 for laser oscillation are successively grown by MBE or MO-CVD. Then, on the active layer 3, a p-In_{0.45}Ga_{0.55} P_{0.92}As_{0.08} cladding layer 8 is grown, which layer does not contain an Al component. This results in a double-heterostructure and is followed by growing an n-GaAs current blocking layer 5 on the said p-cladding layer 8 by MBE or MO-CVD.

Then, as shown in Fig. 1(B), a striped channel 50 for confining current is formed in the current blocking layer 5 by an etching technique, in such a manner that it reaches the p-cladding layer 8 so that the portion of the p-cladding layer 8 corresponding to the bottom portion of the striped channel 50 is exposed. In this example, an etchant, which is a mixture in the proportion of 4 parts H₂SO₄, 2 parts H₂O₂ and 100 parts H₂O at 10°C, is used. This etchant etches GaAs crystal materials, but it cannot etch In_{0.45}Ga_{0.55}P_{0.92}As_{0.08} crystal materials, and accordingly by using this etchant, the above-mentioned striped channel can be formed in the n-GaAs current blocking layer 5 so as to reach the p-In_{0.45}Ga_{0.55}P_{0.92}As_{0.08} cladding layer 8.

Then, as shown in Fig. 1(C), a p-Al_{0.5}Ga_{0.5}As layer 6 and a p-GaAs cap layer 7 are successively grown on the n-GaAs current blocking layer 5 which includes the striped channel 50. Since neither the side portions nor the bottom portion of the striped channel 50 contains an Al component, such as in AlGaAs crystal materials, there can be no Al oxidation, and therefore no problems for succeeding crystal growth are encountered. Thus, a heat-etching treatment of the wafer in a growth chamber is not required.

Using the above mentioned method, a semiconductor laser device according to the present invention is obtained, wherein a double-heterostructure, which is composed of a p-AlGaAs active layer 3 and an n-AlGaAs cladding layer 2 and a p-InGaPAs cladding layer 8, sandwiching said active layer 3 therebetween, is disposed on an n-GaAs substrate 1. Moreover, a current-confining striped structure is disposed on the double-heterostructure. This laser device attains stabilized laser oscillation at an oscillation wavelength ranging from 660 nm to 890 nm. The p-InGaPAs cladding layer 8 which contacts the n-GaAs current blocking layer 5 must be composed of an In₁₋ₛGaₛAs₁₋ₜPₜ crystal material wherein 0.51 ≦ s ≦ 1, 0 ≦ t ≦ 1, and t=2.04s - 1.04, so that the lattice match between the GaAs crystal material and the GaAlAs crystal material can be attained. Even though, as described above, the p-InGaPAs cladding layer 8 was exposed to air, it is not readily oxidized. Moreover, the p-InGaPAs cladding layer 8 functions to confine carrier and light (associated with the p-AlGaAs active layer 3) therein in the same manner as the p-AlGaAs cladding layer 4 shown in Figs. 2(A) to 2(D).

The present invention is not limited to the details of the structure of the above-mentioned laser device. For example, it is also applicable to a structure in which carrier barrier layers or optical guiding layers are disposed between the active layer 3 and the cladding layer 2 and between the active layer 3 and the cladding layer 8, respectively. The present invention is also applicable to a semiconductor laser device with an active layer 3 of In_{1-y}Ga_{y}P_{1-z}As_{z} (wherein 0.51 ≦ y ≦ 1, 0 ≦ z ≦ 1 and z=2.04y - 1.04) is provided as an alternative to GaAlAs.

## Claims

1. A semiconductor laser device comprising a double-heterostructure that is composed of an active layer (3) and a pair of cladding layers (2,8) sandwiching said active layer (3) therebetween, and a stripe structure that is disposed on said double-heterostructure, said stripe structure being composed of a current blocking layer (5) with a conductivity type different from that of the adjacent cladding layer (8), and said current blocking layer (5) having a striped channel (50) constituting a current path, characterised in that said cladding layer (8) that contacts the current blocking layer (5) is composed of an In₁₋ₛGaₛP₁₋ₜAsₜ crystal material, wherein 0.51 ≦ s ≦ 1, 0 ≦ t ≦ 1 and t=2.04s - 1.04, and wherein said current blocking layer (5) is composed of a GaAs crystal material.

2. A semiconductor laser device according to claim 1, wherein said active layer (3) is composed of a GaAlAs crystal material.

3. A semiconductor laser device according to claim 1, wherein said active layer (3) is composed of an In_{1-y}Ga_{y}P_{1-z}As_{z} crystal material, wherein 0.51 ≦ y ≦ 1, 0 ≦ z ≦ 1 and z=2.04y - 1.04.

## Patentansprüche

1. Halbleiterlaser mit Doppel-Heterostruktur, die aus einer aktiven Schicht (3) und einem Paar Auskleidungsschichten (2, 8) aufgebaut ist, zwischen denen eine aktive Schicht (3) liegt, und mit einer Streifenstruktur, die auf der Doppel-Heterostruktur angeordnet ist, wobei die Streifenstruktur aus einer Stromblockierschicht (5) mit einem Leitfähigkeitstypus gebildet ist, der sich von dem der benachbarten Auskleidungsschicht (8) unterscheidet, und wobei die Stromblockierschicht (5) einen Streifenkanal (50) aufweist, der einen Strompfad bildet, **dadurch gekennzeichnet,** daß die Auskleidungsschicht (8), die die Stromblockierschicht (5) kontaktiert, aus einem In₁₋ₛGaₛP₁₋ₜAsₜ-Kristallmaterial zusammengesetzt ist, worin 0,51 ≦ s ≦ 1, 0 ≦ t ≦ 1 und t = 2,04s - 1,04 ist, und wobei die Stromblockierschicht (5) aus einem GaAs-Kristallmaterial gebildet ist.

2. Halbleiterlasereinrichtung nach Anspruch 1, wobei die aktive Schicht (3) aus einem GaAlAs-Kristallmaterial aufgebaut ist.

3. Halbleiterlasereinrichtung nach Anspruch 1, wobei die aktive Schicht (3) aus einem In_{1-y}Ga_{y}P_{1-z}As_{z}-Kristallmaterial gebildet ist, worin 0,51 ≦ y ≦ 1, 0 ≦ z ≦ 1 und z = 2,04y - 1,04 ist.

## Revendications

1. Un dispositif laser à semi-conducteur comprenant une hétérostructure double qui se compose d'une couche active (3) et d'une paire de couches de revêtement (2, 8) prenant ladite couche active (3) en sandwich entre elles, et une structure à bandes qui est disposée sur ladite hétérostructure double, ladite structure à bandes étant composée d'une couche de blocage de courant (5) à type de conductivité différent de celui de la couche de revêtement adjacente (8), et ladite couche de blocage de courant (5) présentant un canal à bandes (50) constituant un trajet pour le courant, caractérisé en ce que ladite couche de revêtement (8) qui vient en contact avec la couche de blocage de courant (5) est en un matériau cristallin In₁₋ₛGaₛP₁₋ₜAsₜ, où 0,51 ≦ s ≦ 1, 0 ≦ t ≦ 1 et t = 2,04s - 1,04, et ladite couche de blocage de courant (5) est composée d'un matériau cristallin GaAs.

2. Un dispositif laser à semi-conducteur suivant la revendication 1, dans lequel ladite couche active (3) est composée d'un matériau cristallin GaAlAs.

3. Un dispositif laser à semi-conducteur suivant la revendication 1, dans lequel ladite couche active (3) est composée d'un matériau cristallin In_{1-y}Ga_{y}P_{1-z}As_{z}, où 0,51 ≦ y ≦ 1,0 ≦ z ≦ 1 et z = 2,04y - 1,04.
